# EUROPEAN PATENT APPLICATION

(11) **EP 4 814 581 A1**
(43) Date of publication of application: **30.09.2026**
(21) Application number: 24893851.6
(22) Date of filing: 20.09.2024
(51) Int. Cl.: G03F 7/20, G21K 5/00, H01J 37/305, H01L 21/265

(54) **CHARGED PARTICLE BEAM TRANSPORT DEVICE AND CHARGED PARTICLE BEAM NEUTRALIZATION METHOD**

(30) Priority: 21.11.2023 JP 2023197236
(71) Applicant: Hitachi, Ltd., Tokyo 100-8280 (JP)
(72) Inventor: NAGASHIMA, Kazuya, Tokyo 100-8280 (JP)
(74) Representative: MERH-IP Matias Erny Reichl Hoffmann Patentanwälte PartG mbB
(86) International application number: PCT/JP2024/033658
(87) International publication number: WO 2025/109856

(57) **Abstract**

A charged particle beam transport device 20 includes one or more injection ports 8a, 8b, and 8c that are arranged along a beam trajectory and through which a neutralizer for space charge neutralization is injected, flow rate regulators 9a, 9b, and 9c that control injection amounts of the neutralizer from the injection ports 8a, 8b, and 8c, and a control device 12, and controls the injection amounts based on evaluation of a space charge distribution and a beam loss rate. Accordingly, a charged particle beam transport device and a charged particle beam neutralization method that achieve a stable supply of a charged particle beam for a long time as compared with the related art are provided.

## Description

### Technical Field

The present invention relates to a charged particle beam transport device and a charged particle beam neutralization method.

### Background Art

As an example of a technique of correcting a space charge effect in a plane of an electron trajectory with high uniformity, neutralizing space charge with efficiency by reducing a loss of an electron beam due to collisions between electrons and ions, and increasing a beam current to achieve high throughput, PTL 1 describes a technique having a function of converging the electron beam emitted from an electron gun, in which an ion generation unit provided around a trajectory region of the electron beam, and an ion irradiation unit that irradiates the trajectory region of the electron beam with an ion beam generated from the ion generation unit are provided, and the space charge formed by the electron beam is neutralized and the space charge effect is reduced by irradiating the trajectory region of the electron beam with the ion beam.

### Citation List

### Patent Literature

PTL 1: JP2007-19195A

### Summary of Invention

### Technical Problem

In the transportation of a charged particle beam, charged particles in the beam diverge due to Coulomb repulsion. This beam divergence is called a space charge effect. To prevent the space charge effect, a beam trajectory is irradiated with charged particles having charges opposite to those of the charged particles in the beam. Accordingly, since both positively and negatively charged particles are present on the beam trajectory, the space charge is reduced.

The technique for preventing the space charge effect with respect to the electron beam is described in PTL 1.

However, when a neutralizer is injected to reduce the space charge effect of the charged particle beam, a reaction also occurs in which the charged particle beam itself is neutralized due to a reaction between the charged particle beam and the neutralizer. Since acceleration and trajectory control cannot be achieved by electromagnetic interaction, the neutralized beam is lost in the beam transportation. That is, the space charge needs to be effectively reduced while minimizing the loss of the charged particle beam.

For this purpose, it is necessary to increase an injection amount of the neutralizer in a portion where a trajectory of the charged particle beam is focused and the space charge is high, whereas to decrease the injection amount of the neutralizer in a region where the trajectory diverges and the space charge is low.

PTL 1 describes a method of uniformly neutralizing the space charge in a vertical plane by irradiating the trajectory of the electron beam with the ion beam from an axisymmetric direction in the vertical plane. In addition, PTL 1 describes a device that reduces the space charge effect with efficiency by adjusting an irradiation position of the ion beam according to the magnitude of a current density.

However, the technique described in PTL 1 is premised on local space charge neutralization in a small system such as an electron beam exposure device.

In a device of a large system such as an industrial or medical charged particle beam accelerator, it is necessary to control the injection amount or the like in consideration of a distribution after a neutralizer is injected. In addition, it is necessary to control the neutralizer distribution in consideration of beam loss due to interaction between a charged particle beam and a neutralizer as well.

To stably supply the charged particle beam for a long time, a device that controls an injection amount and distribution of a neutralizer according to state changes of the charged particle beam and the device is required.

The invention provides a charged particle beam transport device and a charged particle beam neutralization method that achieve a stable supply of a charged particle beam for a long time as compared with the related art.

### Solution to Problem

The invention includes a plurality of methods for solving the above problems, and an example thereof is a charged particle beam transport device including: one or more neutralizer injection portions configured to allow a neutralizer for space charge neutralization to be injected therethrough, the one or more neutralizer injection portions being arranged along a beam trajectory; and an injection amount control device configure to control an injection amount of the neutralizer from each of the one or more neutralizer injection portions, in which the injection amount is controlled based on evaluation of a space charge distribution and a beam loss rate.

### Advantageous Effects of Invention

According to the invention, it is possible to achieve a stable supply of the charged particle beam for a long time as compared with the related art. Problems, configurations, and effects other than those described above will be clarified by the following description of embodiments.

### Brief Description of Drawings

[FIG. 1] FIG. 1 is a schematic configuration diagram of a charged particle beam transport device according to a first embodiment.
[FIG. 2] FIG. 2 is a diagram illustrating a control flow of an injection amount of a space charge neutralizer according to the first embodiment.
[FIG. 3] FIG. 3 is a schematic configuration diagram of a charged particle beam transport device according to a second embodiment.
[FIG. 4] FIG. 4 is a schematic configuration diagram of a charged particle beam transport device according to a third embodiment.
[FIG. 5] FIG. 5 is a diagram illustrating an example of an outline of data recorded in a recording device of the charged particle beam transport device according to the third embodiment.

### Description of Embodiments

Hereinafter, embodiments of a charged particle beam transport device and a charged particle beam neutralization method according to the invention will be described with reference to the drawings. In the drawings used in the present description, the same or corresponding components are denoted by the same or similar reference signs, and repeated descriptions of these components may be omitted.

### <First Embodiment>

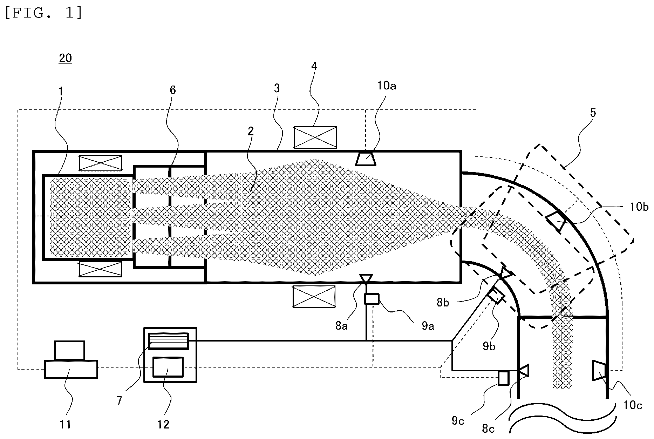

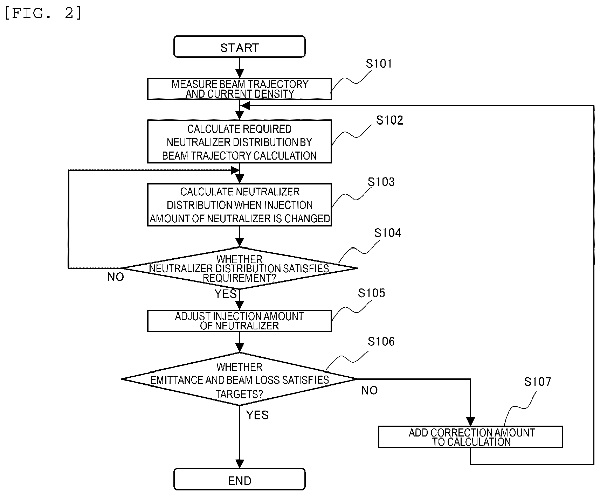

A charged particle beam transport device and a charged particle beam neutralization method according to a first embodiment of the invention will be described with reference to FIGS. 1 and 2.

First, an overall configuration of the charged particle beam transport device will be described with reference to FIG. 1. FIG. 1 is a schematic configuration diagram of the charged particle beam transport device according to the first embodiment.

A charged particle beam transport device 20 illustrated in FIG. 1 is a device for transporting charged particles generated by a plasma generation device 1 to a post-stage device, and includes a charged particle beam 2, a vacuum chamber 3, a converging coil 4, a deflection electromagnet 5, injection ports 8a, 8b, and 8c, flow rate regulators 9a, 9b, and 9c, measuring instruments 10a, 10b, and 10c, a calculation device 11, a control device 12, and the like.

The plasma generation device 1 is a device that generates a charged particle beam, the type of the device includes a microwave ion source, an electron cyclotron resonance (ECR) ion source, a duoplasmatron, an electron gun, and the like, and any device can be used. In the present embodiment, a configuration adopting the microwave ion source will be described as an example.

A plasma generated in the plasma generation device 1 is extracted by a potential difference from an extraction electrode 6, thereby generating the charged particle beam 2.

The charged particle beam 2 is converged by the converging coil 4 in the vacuum chamber 3, deflected by the deflection electromagnet 5, and transported to the post-stage device such as a post-stage accelerator. Here, the converging coil 4 can include a magnetic pole using a magnetic material.

Here, the post-stage accelerator is, for example, a radio frequency accelerator including a radio frequency quadrupole (RFQ), a drift tube Linac (DTL), and the like, which can be used either alone or in combination of both. Alternatively, the post-stage accelerator can also be an electrostatic accelerator such as a Cockcroft-Walton type or a Van de Graaff type. There can also be an electromagnet for trajectory control, a neutralization cell for beam neutralization, or the like.

When transported through an interior of the vacuum chamber 3 or the like, the charged particle beam 2 diverges due to Coulomb repulsion between the charged particles constituting the charged particle beam 2. This is called a space charge effect.

The beam divergence due to the space charge effect can be expressed by the following formula (1).
[Math. 1] $F = e \left(E-vB\right) = \frac{{eρ}_{0} r}{2 {ε}_{0}} \left(1-\frac{{v}^{2}}{{c}^{2}}\right)$

In the formula (1), F is a force acting on the charged particles constituting the charged particle beam 2, and is represented by a function of an electric field E and a magnetic flux density B in a direction perpendicular to a beam traveling direction, and an elementary charge e and a velocity v as in a second term. As can be seen from the above formula, forces due to the electric field and a magnetic field cancel each other.

When the formula is transformed into a function of the elementary charge e, a charge density ρ₀, a permittivity ε₀, a distance r from a center trajectory, a speed c of light, and the velocity v as in a third term, it can be seen that a divergence force increases as the velocity decreases.

It can be seen from the formula (1) that the low-energy charged particle beam 2 before acceleration is more strongly subjected to the space charge effect and diverges.

As an index indicating the divergence of the charged particle beam 2, emittance represented by a phase space area of positions and momenta of the charged particles constituting the beam is used. The emittance increased by the space charge effect, or the like, cannot be reduced unless a special process called beam cooling is used.

For example, when the charged particle beam 2 is converged by the converging coil 4, the charged particles constituting the charged particle beam 2 can be converged at a center of the trajectory, and on the other hand, momentum spread increases. Therefore, even if the charged particle beam 2 is converged by the converging coil 4, the emittance cannot be reduced.

When the emittance is large, the trajectory of the charged particle beam 2 diverges or the momentum spread of the charged particles constituting the charged particle beam 2 is large, and the charged particle beam 2 deviates from a region of stable control in a post-stage transport system or a post-stage accelerator and is lost.

In order not to increase the emittance, it is necessary to reduce Coulomb force expressed by formula (1). Since the Coulomb force is proportional to the charge density, the charge density on the trajectory of the charged particle beam 2 needs to be reduced.

Here, the reduction of the charge density on the trajectory of the charged particle beam 2 refers to that charged particles having charges opposite to those of the charged particle beam 2 are arranged on the trajectory to spatially reduce the charges. This is called reduction or neutralization of space charge.

To neutralize the space charge, there is a method of injecting a neutralizer onto the trajectory of the charged particle beam 2. Here, the neutralizer may be a neutral gas, an electron beam, an ion beam, a plasma, or the like.

For example, when a neutral gas is injected onto the trajectory of the charged particle beam 2, the charged particles in the beam react with the neutral gas, and a reaction occurs in which electrons are ionized from the neutral gas.

When the charged particle beam 2 includes positively charged ions, electrons ionized from the neutral gas are accumulated on the trajectory due to the Coulomb force with beam particles. On the other hand, ions ionized from the neutral gas are removed from the beam trajectory due to a received repulsive force from the charged particle beam 2. In this manner, the electrons are accumulated on the trajectory of the charged particle beam 2 having positive charges, so that the space charge is neutralized.

Even when an electron beam, an ion beam, and a plasma are used as the neutralizer, a beam neutralization process is the same except for an ionization process of the neutral gas.

In the present embodiment, the neutral gas is used as the neutralizer as an example.

One or more injection ports such as the injection ports 8a, 8b, and 8c are arranged along the beam trajectory to inject a neutralizer therethrough for space charge neutralization. In the present embodiment, a case where three injection ports are provided is illustrated as an example, but the number of injection ports is not limited to three, and can be one or more. A plurality of injection ports can also be provided at the same position along the beam trajectory.

The flow rate regulators 9a, 9b, and 9c are provided on pipes connecting a cylinder 7 containing the neutral gas and the injection ports 8a, 8b, and 8c, respectively, and adjust injection amounts of the neutralizer from the injection ports 8a, 8b, and 8c. A control amount for controlling the injection amount is adjusted by the control device 12. It is desirable to provide the same number of flow rate regulators as the injection ports. In the present embodiment, a case where three flow rate regulators are provided is illustrated as an example, but the number of flow rate regulators is not limited to three, and can be one or more. In addition, a plurality of flow rate regulators can also be provided at the same position in a beam trajectory direction. In this case, it is desirable to change positions of the flow rate regulators in a radial direction.

The measuring instruments 10a, 10b, and 10c are measuring devices that measure a beam trajectory or a charge density, and can be, for example, various measuring instruments such as a destructive type using a wire, an electrode, or the like, or a non-destructive type using a gas, an optical sensor, or the like.

Similarly to the injection ports 8a, 8b, and 8c and the flow rate regulators 9a, 9b, and 9c, installation positions and the number of the measuring instruments 10a, 10b, and 10c are not required to be the same as those of the injection ports 8a, 8b, and 8c for the neutralizer, or the like. The trajectory of the charged particle beam 2 outside measurement ranges of the measuring instruments 10a, 10b, and 10c can be estimated from measurement values by beam trajectory calculation or the like. Alternatively, the beam trajectory of the entire beam transport device may be estimated only by beam trajectory calculation without providing the measuring instruments 10a, 10b, and 10c.

The calculation device 11 is a part that evaluates a space charge distribution and a beam loss rate, preferably obtains the injection amounts of the neutralizer based on calculation results of the space charge distribution on the beam trajectory, which is evaluated based on the beam trajectory or the charge density measured by the measuring instruments 10a, 10b, and 10c, the neutralizer distribution, and the beam loss rate, and outputs a signal related to the obtained injection amounts to the control device 12.

The control device 12 receives the signal, obtains adjustment amounts of the flow rate regulators 9a, 9b, and 9c for achieving the injection amounts of the neutralizer from the injection ports 8a, 8b, and 8c, respectively, and controls operations of the flow rate regulators 9a, 9b, and 9c.

The calculation device 11, the control device 12, and a recording device 16 according to a third embodiment to be described later are implemented by, for example, a computer including a display device such as a liquid crystal display, an input device, a recording device, a CPU, a memory, and the like. Operation control of these devices is executed by the calculation device 11 or the control device 12 based on various programs recorded in the recording device.

The operation control processing executed by the calculation device 11 or the control device 12 may be integrated into one program, may be divided into a plurality of programs, respectively, or may be a combination thereof. A part or all of the programs may be implemented by dedicated hardware or may be modularized.

The neutral gas for space charge reduction is injected from the injection ports 8a, 8b, and 8c, and the injection amounts thereof are adjusted by the flow rate regulators 9a, 9b, and 9c.

When the injection amount of the neutralizer is insufficient, the charged particle beam 2 diverges due to insufficient space charge neutralization. On the other hand, when the injection amount of the neutralizer is excessive, the charged particles in the charged particle beam 2 and the charged particles having opposite charges interact with each other, and thus the charged particle beam 2 is neutralized.

The neutralized charged particle beam 2 is not deflected by the deflection electromagnet 5 and is thus lost without being transported to the post-stage device. Since the neutralized beam cannot be controlled by an electromagnetic force, the trajectory thereof cannot be controlled and the neutralized beam is lost even in a configuration other than the present embodiment.

To prevent the beam divergence by the space charge neutralization to a specification required by the device while minimizing the loss of the charged particle beam 2 due to the neutralizer injection, it is necessary to control the neutralizer distribution according to the space charge distribution on the beam trajectory.

In a region where the space charge on the beam trajectory is high, the beam divergence due to the space charge effect is large, and thus it is necessary to increase a neutralizer density. On the other hand, since the space charge effect is small in a region where the space charge on the beam trajectory is low, it is necessary to reduce the neutralizer density in consideration of the loss due to the beam neutralization.

As described above, by measuring the trajectory and the charge density of the charged particle beam 2 with the measuring instruments 10a, 10b, and 10c, the space charge distribution on the beam trajectory at any given time can be evaluated in substantially real time.

Here, linear calculation using a transfer matrix or numerical simulation such as particle in cell (PIC) can be used for the beam trajectory calculation.

Since the charge distribution on the trajectory of the charged particle beam 2 can be evaluated by the above trajectory calculation, the amount and distribution of the neutral gas required for neutralization can be determined.

The neutral gas distribution in the vacuum chamber 3 can be calculated by molecular flow simulation, assuming that the mean free path is sufficiently long.

The number of electrons ionized from the neutral gas can be expressed by a velocity of the charged particle beam 2, a cross-sectional area, and respective densities. The generated electrons diffuse and disappear due to energy at the time of generation, a space potential distribution, recombination with the charged particle beam 2, and the like.

An electron density on the trajectory of the charged particle beam 2 when the neutral gas is injected is expressed by formula (2).
[Math. 2] ${p}_{e} = {ρ}_{i} \times {ρ}_{n} \times σ \times v \times d$

In the formula (2), ρₑ, ρᵢ, and ρₙ represent densities of electrons, beam particles, and neutral gas. σ, v, and d represent a cross-sectional area of the beam and the neutral gas, a velocity of the beam particles, and a diffusion and loss coefficient.

The densities ρᵢ and ρₙ can be determined by the beam trajectory calculation, the molecular flow simulation, or the like. The velocity v of the beam particles is determined based on an acceleration condition. For the cross-sectional area σ, data on the cross-sectional area can be referred to.

The diffusion and loss coefficient d can be obtained by numerical calculation using PIC or a fluid model. This coefficient can also be experimentally determined.

A neutralization rate of the charged particle beam 2 due to the neutral gas injection can also be determined by numerical simulation or experiments.

The emittance after the space charge neutralization can be evaluated by incorporating the electron density and the neutralization rate on the trajectory of the charged particle beam 2 into the beam trajectory calculation.

The trajectory calculation in consideration of the space charge neutralization can be executed by multiplying a charge density by the space charge neutralization rate as in formula (3) in the Poisson equation during the calculation.
[Math. 3] $ΔΦ \left(x, y, z\right) = \frac{ρ \left(x, y, z\right)}{{ε}_{0}} \times α$

In the formula (3), ΔΦ represents a potential, ρ represents the charge density of the charged particle beam 2, and ε₀ represents the permittivity of vacuum. By multiplying the charge density ρ by a space charge neutralization rate α, the potential when the space charge is neutralized can be calculated.

The space charge neutralization rate α can be expressed by formula (4) obtained by dividing formula (2) by the charge density ρᵢ of the charged particle beam 2.
[Math. 4] $α = {ρ}_{n} \times σ \times v \times d$

Since the beam neutralization rate is proportional to the number of electrons on the beam trajectory, the beam loss rate due to neutralization can also be obtained.

The beam trajectory calculation in consideration of the space charge neutralization as described above may be a method of solving all interactions between the charged particle beam 2 and particles of the neutral gas by the Monte Carlo method. However, in the current computer performance, it is impossible to calculate behaviors of all charged particles, so that an approximation method of calculating only superparticles obtained by collecting a large number of particles is used.

In addition, a calculation method such as fluid simulation can also be applied. However, there is a problem in experimental reproducibility, and thus it is necessary to apply an appropriate calculation method for each evaluation system.

As described above, the required neutralizer distribution can be calculated by the beam trajectory calculation for the entire beam transport device.

In an actual operation, it is desirable that the space charge distribution and the required neutral gas distribution of the entire beam transport device are evaluated by the calculation device 11 based on the beam trajectory measured by the measuring instruments 10a, 10b, and 10c. Based on the evaluation result, the control device 12 controls the plurality of flow rate regulators 9a, 9b, and 9c to adjust the injection amounts of the neutralizer from the injection ports 8a, 8b, and 8c.

A control flow of the injection amounts and positions of the neutralizer in the present embodiment will be described with reference to FIG. 2. FIG. 2 is a diagram illustrating a control flow of the injection amounts of a space charge neutralizer.

Step S101: the trajectory and a current density of the charged particle beam 2 are measured by the measuring instruments 10a, 10b, and 10c.

Step S102: the calculation device 11 calculates the space charge distribution on the beam trajectory and the required neutralizer distribution based on measurement results of the measuring instruments 10a, 10b, and 10c measured in step S101.

Step S103: the neutralizer distribution when the injection amounts from the injection ports 8a, 8b, and 8c are changed is calculated by the molecular flow simulation.

Step S104: it is determined whether the neutralizer distribution calculated in step S103 satisfies a required value. If the required value is not satisfied, the process returns to step S103 to calculate the neutralizer distribution under a different condition. If the required value is satisfied, the process proceeds to step S105.

Step S105: the control device 12 controls the flow rate regulators 9a, 9b, and 9c to adjust the injection amounts of the neutralizer, so that the condition satisfies the requirement in step S104.

Step S106: it is determined whether the beam satisfies a target value in step S105. Here, an index other than the emittance may be used to indicate a beam divergence amount. When the emittance and the beam loss rate satisfy the target values, the control flow ends. On the other hand, when the emittance and the beam loss rate do not satisfy the target values, step S107 is executed.

Step S107: When the target values are not satisfied in step S106, a difference between a calculation result and a measurement result after the neutralizer distribution is adjusted is added as a correction amount, and the control flow is executed again by repeating the calculation in step S102.

Next, effects of the present embodiment will be described.

The charged particle beam transport device 20 according to the first embodiment of the invention described above includes one or more injection ports 8a, 8b, and 8c that are arranged along the beam trajectory and through which the neutralizer for space charge neutralization is injected, the flow rate regulators 9a, 9b, and 9c that control the injection amounts of the neutralizer from the injection ports 8a, 8b, and 8c, and the control device 12, and controls the injection amount based on evaluation of the space charge distribution and the beam loss rate.

Accordingly, for the entire charged particle beam, since the injection amounts and the positions of the neutralizer are controlled in consideration of the charged particle beam trajectory and the neutralizer distribution in the whole beam transport system, the space charge is efficiently reduced while reducing the loss due to the beam neutralization, so that beam transport with low divergence and high efficiency is achieved. Therefore, it is possible to achieve a stable supply of the charged particle beam for a long time as compared with the related art.

Such a charged particle beam transport device 20 is suitable for a linear accelerator, and is also applicable to an ion supply source in a nuclear fusion reactor, a boron neutron capture therapy (BNCT), or a particle beam therapy device using a synchrotron accelerator.

The charged particle beam transport device 20 further includes the calculation device 11 that evaluates the space charge distribution and the beam loss rate. Since the calculation device 11 obtains the injection amount based on calculation results of the space charge distribution on the beam trajectory, the neutralizer distribution, and the beam loss rate, it is possible to control the injection amount of the neutralizer according to a state of the charged particle beam using the processing described above.

The charged particle beam transport device 20 further includes the measuring instruments 10a, 10b, and 10c that measure the beam trajectory or the charge density. By evaluating the space charge distribution based on the beam trajectory or the charge density measured by the measuring instruments 10a, 10b, and 10c, it is possible to control the injection amount of the neutralizer according to the state of the charged particle beam at any given time.

In the above embodiment, although a mode in which the calculation device 11 evaluates the space charge distribution and the beam loss rate using the measurement results of the measuring instruments 10a, 10b, and 10c has been described as an example, a mode may be adopted in which an operator evaluates the space charge distribution and the beam loss rate using the measurement results of the measuring instruments 10a, 10b, and 10c. In this case, the injection amount of the neutralizer for space charge neutralization is also manually controlled by the operator.

Alternatively, a mode may also be adopted in which the space charge distribution and the beam loss rate are evaluated in advance by beam trajectory calculation or the like in design and manufacturing stages of the charged particle beam transport device 20, without providing the measuring instruments 10a, 10b, and 10c, and the injection amount of the neutralizer is controlled automatically or manually based on the evaluation results in the design and manufacturing stages.

### <Second Embodiment>

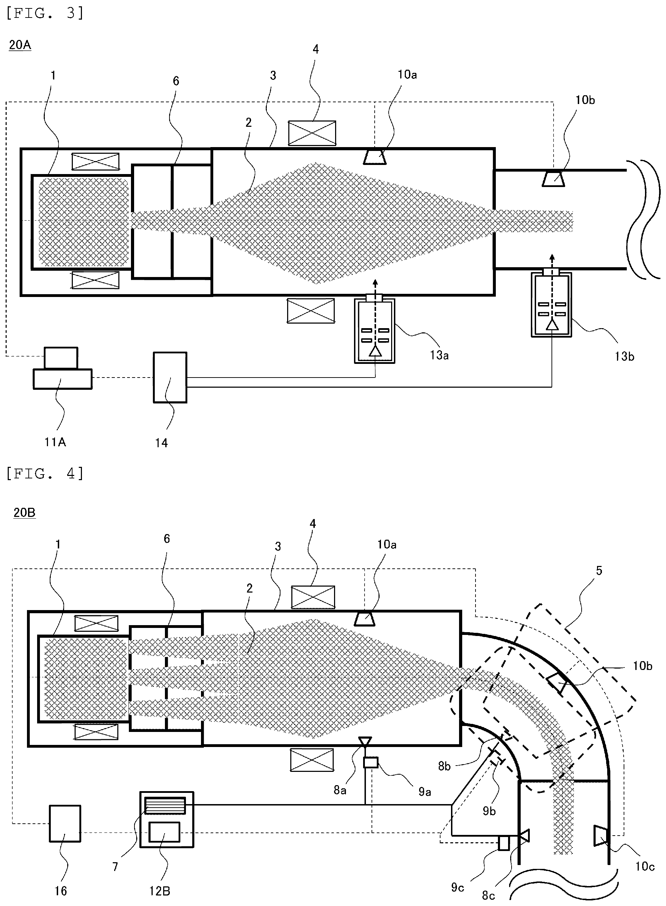

A charged particle beam transport device and a charged particle beam neutralization method according to a second embodiment of the invention will be described with reference to FIG. 3. FIG. 3 is a schematic configuration diagram of the charged particle beam transport device according to the second embodiment.

A charged particle beam transport device 20A according to the present embodiment illustrated in FIG. 2 is a system that uses either electrons or ions as a neutralizer and that neutralizes space charge on a beam trajectory by generating electrons or ions.

When an electron beam, an ion beam, or a plasma is used as the neutralizer, an electron gun, an ion source, a plasma source, or the like is used, thereby controlling an injection amount by a device configuration such as a voltage applied thereto, a current, or an incident angle.

For example, one or more ion generation devices 13a and 13b are arranged along a trajectory of the charged particle beam 2 to generate an ion beam having charges opposite to those of the charged particle beam 2. An ion generation method may be a filament type or a microwave type.

The trajectory of the charged particle beam 2 is irradiated with ions generated by the ion generation devices 13a and 13b by a potential difference.

An irradiation amount of the ion beam can be controlled by a current or a voltage supplied from a power supply 14. The irradiation amount of the ion beam can also be controlled by changing a flow rate of a gas injected into the ion generation devices 13a and 13b for ion generation.

The irradiation amount of the ion beam is controlled in the same manner as in the first embodiment.

Similarly to the first embodiment, based on the trajectory of the charged particle beam 2 measured by the measuring instruments 10a, 10b, and 10c, a calculation device 11A calculates a space charge distribution and the required neutralizer distribution. Then, the irradiation amounts from the ion generation devices 13a and 13b are adjusted based on the calculation results.

Other configurations and operations are substantially the same as those of the charged particle beam transport device and the charged particle beam neutralization method according to the first embodiment described above, and details thereof will be omitted.

In the charged particle beam transport device and the charged particle beam neutralization method according to the second embodiment of the invention as well, substantially the same effects as those of the charged particle beam transport device and the charged particle beam neutralization method according to the first embodiment described above can be obtained.

### <Third Embodiment>

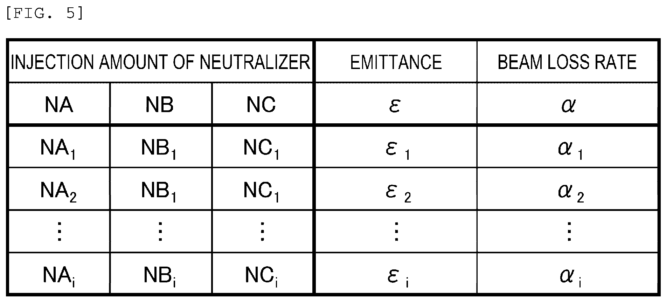

A charged particle beam transport device and a charged particle beam neutralization method according to a third embodiment of the invention will be described with reference to FIGS. 4 and 5. FIG. 4 is a schematic configuration diagram of the charged particle beam transport device according to the third embodiment, and FIG. 5 is a diagram illustrating an example of an outline of data recorded in a recording device.

A charged particle beam transport device 20B according to the present embodiment illustrated in FIG. 4 has a configuration in which the calculation device 11 in the charged particle beam transport device 20 according to the first embodiment is replaced with the recording device 16 having a table in which injection amounts of a neutralizer for each beam condition are recorded, and in which the flow rate regulators 9a, 9b, and 9c and a control device 12B control the injection amounts with reference to the table for each beam condition.

In the present embodiment, emittance and beam loss rate are measured or calculated in advance for the injection amounts of the neutralizer from the injection ports 8a, 8b, and 8c, and measurement or calculation results are stored in the recording device 16. The data stored in the recording device 16 is the table illustrating the emittance and the beam loss rate for each injection amount of the neutralizer as illustrated in FIG. 5.

Then, the control device 12B refers to a required injection amount of the neutralizer according to a beam condition to be used, and adjusts the flow rate regulators 9a, 9b, and 9c based on a reference result.

In the present embodiment, when a beam condition to be used is changed, it is necessary to create a table for each beam condition. In addition, to control the injection amounts of the neutralizer corresponding to the beam condition to be changed during operation, it is necessary to prepare a table comprehensively for the beam condition.

Other configurations and operations are substantially the same as those of the charged particle beam transport device and the charged particle beam neutralization method according to the first embodiment described above, and details thereof will be omitted.

In the charged particle beam transport device and the charged particle beam neutralization method according to the third embodiment of the invention as well, substantially the same effects as those of the charged particle beam transport device and the charged particle beam neutralization method according to the first embodiment described above can be obtained.

Since the recording device 16 having the table in which the injection amounts of the neutralizer for each beam condition are recorded is provided, the flow rate regulators 9a, 9b, and 9c and the control device 12B control the injection amounts with reference to the table for each beam condition, a calculation time as in the first embodiment is not required, so that quick control is possible.

The third embodiment is not limited to the mode in which a neutral gas is used as the neutralizer, and can be a mode in which electrons or ions are injected as in the second embodiment.

### <Others>

The invention is not limited to the embodiments described above, and includes various modifications. The embodiments described above have been described in detail to facilitate understanding of the invention, and the invention is not necessarily limited to those including all the configurations described above.

A part of a configuration in one embodiment can also be replaced with a configuration in another embodiment, and a configuration in one embodiment can also be added to a configuration in another embodiment. A part of a configuration in each embodiment may also be added to, deleted from, or replaced with another configuration.

### Reference Signs List

1: plasma generation device
2: charged particle beam
3: vacuum chamber
4: converging coil
5: deflection electromagnet
6: extraction electrode
7: cylinder
8a, 8b, 8c: injection port (neutralizer injection portion)
9a, 9b, 9c: flow rate regulator (injection amount control device)
10a, 10b, 10c: measuring instrument (measuring device)
11, 11A: calculation device
12, 12B: control device (injection amount control device)
13a, 13b: ion generation device
14: power supply
16: recording device
20, 20A, 20B: charged particle beam transport device

## Claims

1. A charged particle beam transport device comprising:
one or more neutralizer injection portions configured to allow a neutralizer for space charge neutralization to be injected therethrough, the one or more neutralizer injection portions being arranged along a beam trajectory and; and
an injection amount control device configured to control an injection amount of the neutralizer from each of the one or more neutralizer injection portions, wherein
the injection amount is controlled based on evaluation of a space charge distribution and a beam loss rate.

2. The charged particle beam transport device according to claim 1, further comprising:
a calculation device configured to evaluate the space charge distribution and the beam loss rate, wherein
the calculation device obtains the injection amount based on calculation results of the space charge distribution on the beam trajectory, a neutralizer distribution, and the beam loss rate.

3. The charged particle beam transport device according to claim 1, comprising:
a recording device having a table in which an injection amount of the neutralizer for each beam condition is recorded, wherein
the injection amount control device controls the injection amount with reference to the table for each beam condition.

4. The charged particle beam transport device according to claim 2 or 3, further comprising:
a measuring device configured to measure the beam trajectory or a charge density, wherein
the space charge distribution is evaluated based on the beam trajectory or the charge density measured by the measuring device.

5. The charged particle beam transport device according to claim 1, wherein
any one of neutral gas, electrons, and ions is used as the neutralizer.

6. A charged particle beam neutralization method comprising:
injecting a neutralizer for space charge neutralization from one or more neutralizer injection portions that are arranged along a beam trajectory based on evaluation of a space charge distribution and a beam loss rate.
